# EUROPEAN PATENT SPECIFICATION

(11) **EP 3 723 460 B1**
(45) Date of publication and mention of the grant of the patent: **13.04.2022**
(21) Application number: 19214343.6
(22) Date of filing: 09.12.2019
(51) Int. Cl.: H05K 7/14

(54) **INVERTER STACK CAPABLE OF STRUCTURE MODIFICATION**
INVERTERSTAPEL MIT FÄHIGKEIT ZUR STRUKTURMODIFIKATION
EMPILEMENT D'INVERSEUR APTE À LA MODIFICATION DE STRUCTURE

(30) Priority: 12.04.2019 KR 20190043326
(43) Date of publication of application: 14.10.2020
(73) Proprietor: Korea Plant Service & Engineering Co., Ltd., Naju-si 58326 (KR)
(72) Inventor: BAE, Young Sang, 58217 Naju-si (KR); PARK, Jin Soo, 62281 Gwangsan-gu (KR); PARK, Ill Ho, 61766 Nam-gu (KR)
(74) Representative: Heinze, Ekkehard

(56) References cited:
- JP-A- 2012 222 990
- KR-A- 20140 126 574
- KR-A- 20160 069 367
- US-A1- 2009 015 190

## Description

### CROSS-REFERENCE TO RELATED APPLICATION

This application claims the benefit of priority to Korean Patent Application No. 10-2019-0043326, filed in the Korean Intellectual Property Office on April 12, 2019.

### TECHNICAL FIELD

The present disclosure relates to an inverter stack capable of structure modification, and more particularly, relates to an inverter stack that is capable of selective structure modification and is applicable to various power converters.

### BACKGROUND

Power conversion using inverters is essential not only for new renewable energy, such as sunlight, wind power, fuel cells, and the like, but also for system interconnection. The inverters are devices that change direct current (DC) to alternating current (AC).

Specifically, the inverters may be classified into an integrated structure and a modular structure in terms of the structures and functions thereof. The integrated structure is a system in which one inverter or a plurality of inverters having inputs and outputs connected in parallel are connected with one output filter. The modular structure is a system in which one inverter or a plurality of inverters connected in parallel and an output filter are divided with regard to the total capacity.

In the case of the inverters in the related art, it is impossible to change the installation directions and the input/output terminal fastening methods determined in the initial design steps. Accordingly, parallel connection structures of modules of the inverters cannot be diversely modified, and therefore it is difficult to accept the requirements for power converters capable of various configurations. Due to this, the part configurations and designs of the inverters differ from one another according to the products, and it is difficult to unify the inverters into a single product family.

Besides, there is no inverter capable of applying both a modular structure and an integrated structure. Therefore, high development and management costs and much time are taken to configure an inverter system having various structures not only during the initial development but also after the development.

KR 2016 0069367 A1 discloses an inverter stack according to preamble of claim 1. Further related art is disclosed in JP 2012 222990 A, US 2009/015190 A1, and KR 2014 0126574 A.

### SUMMARY

The present disclosure has been made to solve the above-mentioned problems occurring in the prior art while advantages achieved by the prior art are maintained intact.

The above-mentioned problems are solved by an inverter stack with the features of claim 1.

An aspect of the present disclosure provides an inverter stack for enabling easy access to a market requiring the inverter stack by diversely modifying the installation method of the inverter stack or the structure for connecting the inverter stack in parallel.

Another aspect of the present disclosure provides an inverter stack for reducing development time for configuring an inverter system having various structures, and achieving cost savings.

The technical problems to be solved by the present disclosure are not limited to the aforementioned problems, and any other technical problems not mentioned herein will be clearly understood from the following description by those skilled in the art to which the present disclosure pertains.

According to an aspect of the present disclosure, an inverter stack capable of structure modification includes a case having an interior space and including a main body frame and a cover, a circuit unit provided in the interior space, an inverter controller provided in the interior space and connected to the circuit unit to transfer a signal, and a bus bar provided in the case and connected to the circuit unit, the bus bar being electrically connected to a power supply. The main body frame includes a front part, a rear part facing the front part, an upper part provided at the tops of the front part and the rear part, and a lower part facing the upper part, and the cover is detachably coupled to the main body frame and covers the main body frame. The bus bar includes a modular bus bar that is formed to protrude from the rear part of the main body frame and that passes through the cover and an integrated bus bar provided on at least one pair of parts facing each other, among the front part, the rear part, the upper part, and the lower part, the integrated bus bar being covered with the cover. The inverter stack is selectively changed to a modular structure in which the modular bus bar is connected with the power supply or an integrated structure in which the integrated bus bar is connected with the power supply, by coupling the cover to the main body frame or separating the cover from the main body frame.

### BRIEF DESCRIPTION OF THE DRAWINGS

The above and other objects, features and advantages of the present disclosure will be more apparent from the following detailed description taken in conjunction with the accompanying drawings:
FIGS. 1 and 2 are perspective views illustrating an inverter stack having a modular structure according to the present disclosure;
FIG. 3 is a side view of the inverter stack in FIG. 1;
FIG. 4 is a perspective view illustrating a state in which a rear cover is separated in FIG. 2;
FIG. 5 is an operational view illustrating a process of changing the structure of the inverter stack according to the present disclosure;
FIG. 6 is a perspective view illustrating an inverter stack having an integrated structure according to the present disclosure;
FIG. 7 is a perspective view illustrating a state in which the inverter stack illustrated in FIG. 6 is connected in parallel; and
FIGS. 8 and 9 are perspective views illustrating a state in which the inverter stack of FIG. 1 is mounted in an enclosure.

### DETAILED DESCRIPTION

Hereinafter, exemplary embodiments of the present disclosure will be described in detail with reference to the accompanying drawings.

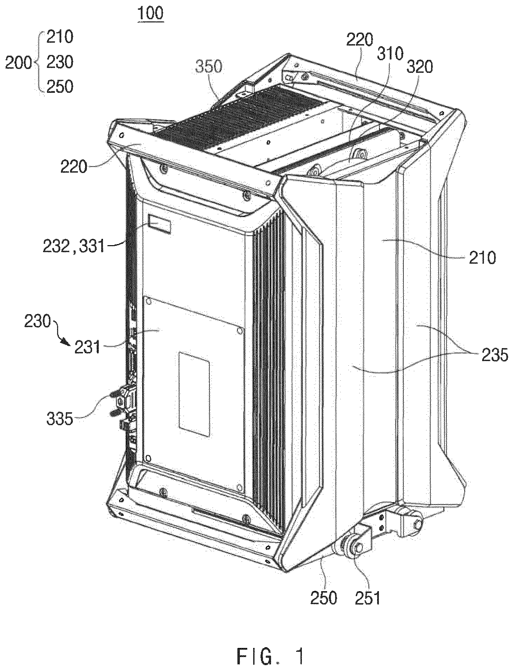

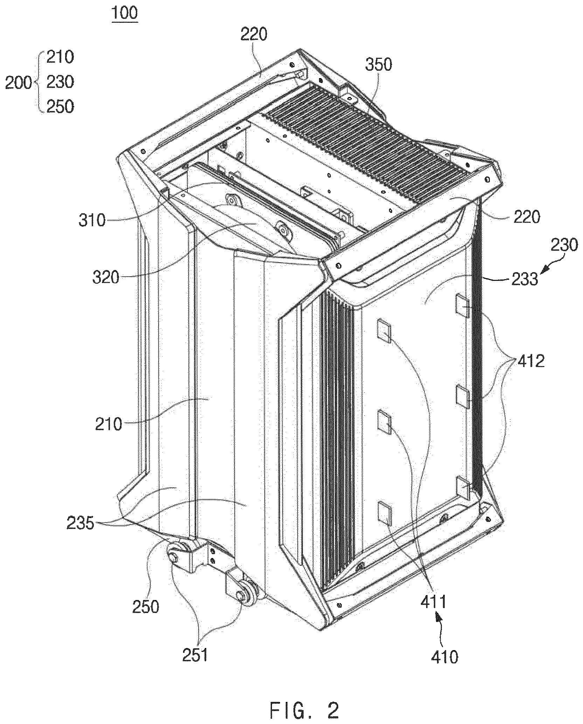

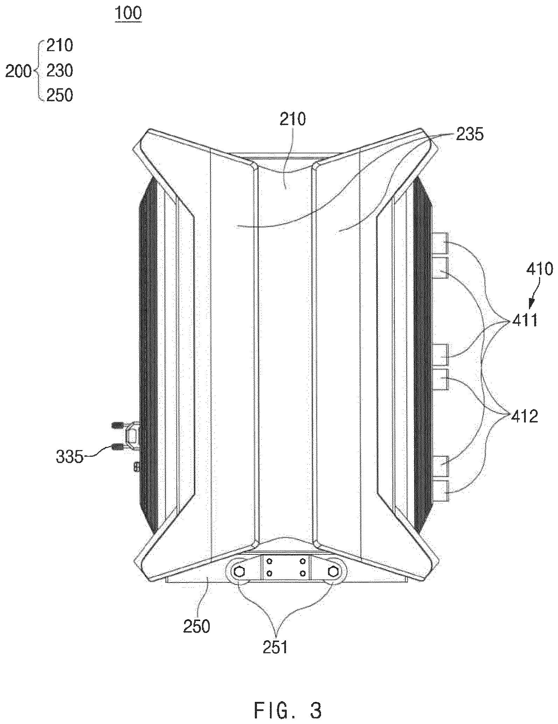

Referring to FIGS. 1 to 3, an inverter stack 100 capable of structure modification according to an embodiment of the present disclosure includes a case 200, a circuit unit 310, an inverter controller, and a bus bar 400.

The case 200 may include a main body frame 210 and a cover 230 and may have an interior space therein.

The main body frame 210 includes a front part, a rear part facing the front part, an upper part provided at the tops of the front part and the rear part, and a lower part facing the upper part. The main body frame 210 may include a pair of side parts that are provided on opposite sides of the front part and the rear part and that face each other.

Specifically, the main body frame 210 may be equipped with the circuit unit 310, the inverter controller, and the bus bar 400 and may be provided in the form of a frame. Further, for exposure of the bus bar 400, the surfaces of the main body frame 210 may be formed to be at least partially open.

The cover 230 is detachably coupled to the main body frame 210 and covers the main body frame 210. Specifically, to protect parts, such as the circuit unit 310, which are installed in the main body frame 210, the cover 230 may be coupled to the main body frame 210 to cover the parts. For example, the cover 230 may be coupled to the main body frame 210 with screws. However, the way in which the cover 230 is coupled to the main body frame 210 is not limited thereto, and various changes and modifications can be made to detachably couple the cover 230.

The circuit unit 310 is provided in the interior space of the case 200. Specifically, the control circuit 310 may be mounted in the main body frame 210 and may be covered with the cover 230.

The circuit unit 310 may include a power conversion semiconductor and a charging capacitor 320. The power conversion semiconductor may include a switching semiconductor element, which may be, for example, an insulated gate bipolar transistor (IGBT) . The charging capacitor 320 may be a DC capacitor. However, the power conversion semiconductor and the charging capacitor 320 are not limited thereto. The circuit unit 310 may further include a snubber.

The inverter controller is provided in the interior space of the case 200 and is connected to the circuit unit 310 to transfer signals. Specifically, the inverter controller may be implemented with a gate control unit (GCU) 330. The gate control unit (GCU) 330 may serve as a medium that provides information regarding the inverter stack 100 to a main control unit (MCU) outside the case 200 and transfers signals from the main control unit (MCU) to the switching semiconductor element (IGBT). The gate control unit 330 may be installed on the front part or the side parts of the main body frame 210. The gate control unit 330 may include an output terminal 335.

The inverter stack 100 according to the present disclosure may further include a heat sink 350 that is provided in the main body frame 210 and that dissipates heat to the outside.

The bus bar 400 is provided in the case 200 and is connected to the circuit unit 310. The bus bar 400 is electrically connected to a power supply. Specifically, the bus bar 400 includes modular bus bars 410 and integrated bus bars 450.

The modular bus bars 410 are formed to protrude from the rear part of the main body frame 210 and pass through the cover 230. In the state in which the cover 230 is completely mounted on the main body frame 210, the modular bus bars 410 may be exposed through a rear cover 233 attached to the rear part of the main body frame 210 and may be connected to the power supply. The modular bus bars 410 may include DC slide bus bars 411 connected to a DC power supply and AC slide bus bars 412 connected to an AC power supply. The modular bus bars 410 may be connected to the circuit unit 310 so as to be removable.

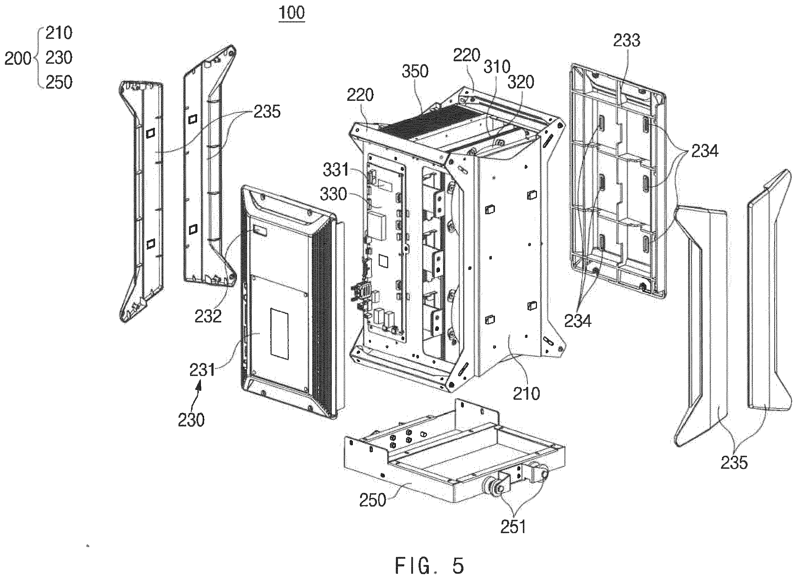

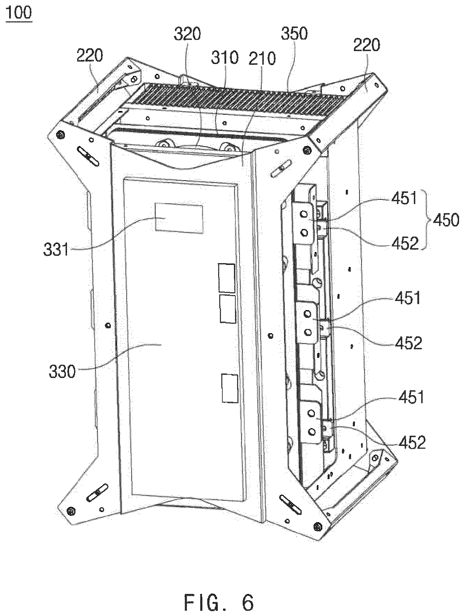

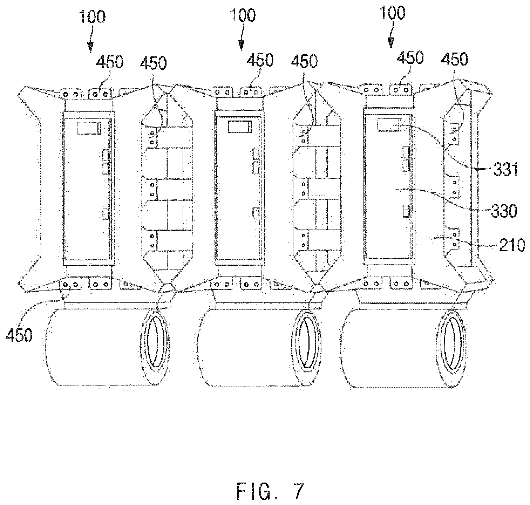

The integrated bus bars 450 are provided on at least one pair of parts facing each other, among the front part, the rear part, the upper part, and the lower part of the main body frame 210. The integrated bus bars 450 are covered with the cover 230. For example, a pair of integrated bus bars 450 may be provided on the front part and the rear part of the main body frame 210 (refer to FIGS. 5 and 6) . Alternatively, a pair of integrated bus bars 450 may be provided on the front part and the rear part of the main body frame 210, and a pair of integrated bus bars 450 may be provided on the upper part and the lower part of the main body frame 210 (refer to FIG. 7). In another case, although not illustrated, a pair of integrated bus bars 450 may be provided on the upper part and the lower part of the main body frame 210. The integrated bus bars 450 may include DC connection bus bars 451 connected to a DC power supply and AC connection bus bars 452 connected to an AC power supply.

The structure of the above-configured inverter stack 100 is selectively changed to a modular structure in which the modular bus bars 410 are connected with the power supply or an integrated structure in which the integrated bus bars 450 are connected with the power supply, by coupling the cover 230 to the main body frame 210 or separating the cover 230 from the main body frame 210.

That is, the inverter stack 100 according to the present disclosure includes both the modular bus bars 410 and the integrated bus bars 450 that are connected to the power supply in different forms, and thus the inverter stack 100 may have a structure that is able to be changed to both the modular structure and the integrated structure.

Specifically, the inverter stack 100 may be classified into the integrated structure and the modular structure in terms of the structure and function thereof. The integrated structure is a system in which one inverter stack 100 or a plurality of inverter stacks 100 having inputs and outputs connected in parallel are connected with one output filter. The inverter stack 100 having the integrated structure needs maintenance of the entire system if the inverter stack 100 fails, but is advantageous in terms of simple configuration, easy control, and low cost. The modular structure is a system in which one inverter stack 100 or a plurality of inverter stacks 100 connected in parallel and an output filter are divided with regard to the total capacity. The inverter stack 100 having the modular structure is a system that is able to be continuously operated using the remaining inverter stack 100 if one inverter stack 100 fails and is able to be separately operated depending on control design. The total capacity may vary depending on the number of inverter stacks 100 connected in parallel.

The inverter stack 100 may be mounted in an enclosure having input and output terminals. In this case, there is a difference in the installation form and the parallel connection method between the modular structure and the integrated structure. In general, the inverter stack 100 having the integrated structure may be mounted on the inner wall of the enclosure, and the integrated bus bars 450 arranged in the up/down direction or the fore/aft direction may be connected together or may be connected to the power supply through cables.

The inverter stack 100 having the modular structure may be installed on a mounting 10 provided in the enclosure. The mounting 10 may include a mounting frame 11, mounting bus bars 12 provided on the mounting frame 11, and slide terminal recesses 15 that are provided on the mounting bus bars 12 and into which the modular bus bars 410 are inserted. Further, a flat plate parallel to the ground may be coupled to the mounting frame 11, and the case 200 may be seated on the flat plate. As many slide terminal recesses 15 and mounting bus bars 12 as the modular bus bars 410 may be provided, and an insulator 13 may be provided between the mounting bus bars 12 and between the mounting bus bars 12 and the mounting frame 11.

In the state of being seated on the flat plate, the inverter stack 100 having the modular structure may be connected to the power supply through the slide terminal recesses 15 provided in the direction toward the rear surface of the inverter stack 100. In the case where the plurality of inverter stacks 100 are connected in parallel, a plurality of mountings 10 may be provided in the enclosure, and the inverter stacks 100 individually mounted on the respective mountings 10 may be connected in parallel by separate members of the enclosure. As will be described below, the inverter stack 100 according to the present disclosure may separately include a base plate 500 that functions as the flat plate.

The bus bar 400 applied to the present disclosure may include both the modular bus bars 410 and the integrated bus bars 450 that are provided in different positions, and the structure of the inverter stack 100 may be changed to the integrated structure or the modular structure by a simple process of coupling or separating the cover 230. Furthermore, the present disclosure may change the structure even without a separate new internal part added.

When the cover 230 is coupled to the main body frame 210, the inverter stack 100 may have the modular structure, and when the cover 230 is separated from the main body frame 210, the inverter stack 100 may have the integrated structure. The change of the structure may be determined depending on a consumer's request, considering the function and the price.

As described above, the present disclosure may implement both the modular structure and the integrated structure using one inverter stack 100, and thus the installation method of the inverter stack or the structure for connecting the inverter stack 100 in parallel may be diversely modified, which makes it possible to easily access a market requiring the inverter stack 100. In addition, the present disclosure may reduce development time for configuring an inverter system having various structures and may achieve cost savings.

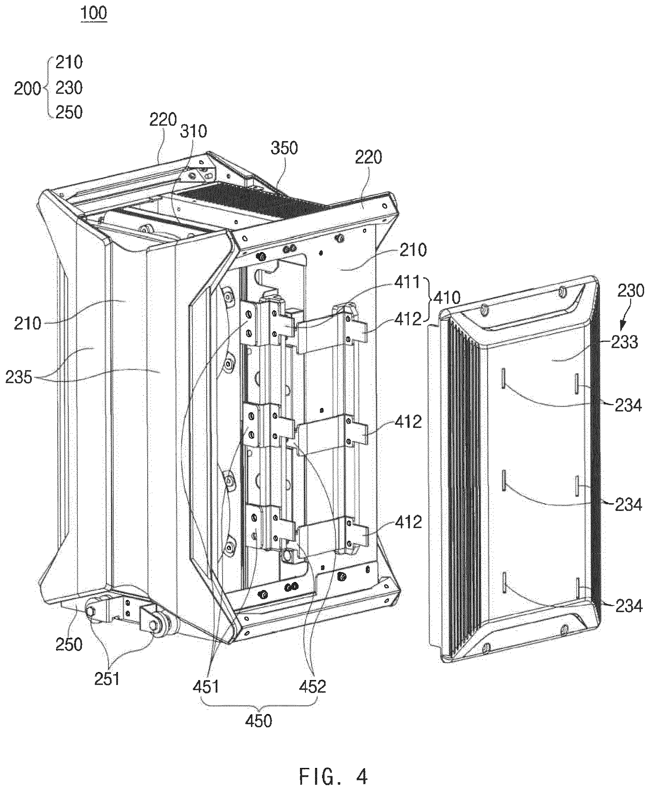

Referring to FIGS. 1 to 4 and 5, the cover 230 according to the present disclosure may include a front cover 231, the rear cover 233, and a pair of side covers 235.

The front cover 231 may cover the front part of the main body frame 210. The rear cover 233 may cover the rear part of the main body frame 210 and may have through-holes 234 formed therein, through which the modular bus bars 410 pass. The number and positions of the through-holes 234 may correspond to the number and positions of the modular bus bars 410. The side covers 235 may cover the side parts on the opposite sides of the front part and the rear part of the main body frame 210.

The gate control unit 330 may be attached to the front part of the main body frame 210 when the modular structure is applied (refer to FIG. 5). Further, when the structure is changed from the modular structure to the integrated structure, the gate control unit 330 may be attached to the side parts on the opposite sides of the front part and the rear part of the main body frame 210 (refer to FIG. 6). Accordingly, the separate gate control unit 330 may not be required because the existing part is used when the structure is changed.

The gate control unit 330 may be equipped with an indicator 331 that indicates whether the inverter stack 100 is in good condition. The cover 230 may include the front cover 231 that covers the front part of the main body frame 210 and has an indication hole 232 for the indicator 331.

Specifically, the indicator 331 may be implemented with a liquid crystal display (LCD) and may immediately indicate a failure state of the inverter stack 100. Furthermore, even in the case of the inverter stack 100 having the integrated structure, whether the inverter stack 100 fails may be intuitively identified because the indicator 331 is included in the gate control unit 330 and the gate control unit 330 is moved to the front part of the main body frame 210 when the structure is changed to the integrated structure.

More specifically, the inverter stacks 100 are generally connected in parallel to increase the capacity irrespective of the structure, and therefore individual failure states of the respective inverter stacks 100 have to be able to be intuitively monitored. In particular, whether fans used in the inverter stacks 100 fail or not, temperature, over-current, and whether there is a direct failure in the switching semiconductor element (IGBT) have to be immediately identified, and countermeasures have to be rapidly taken. However, in the related art, there are no monitoring devices, and therefore separate external monitoring devices have to be provided for the respective inverter stacks 100. The present disclosure integrates the gate control unit 330 and the indicator 331, thereby solving the problem mentioned above.

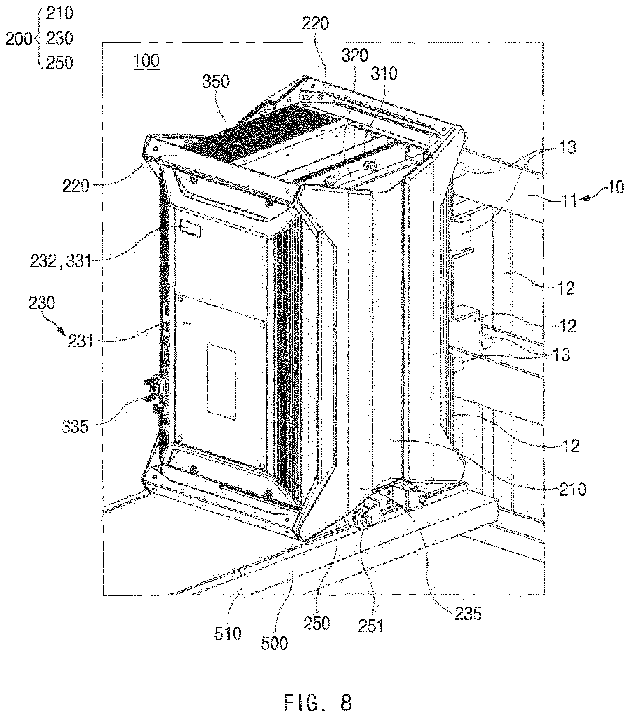

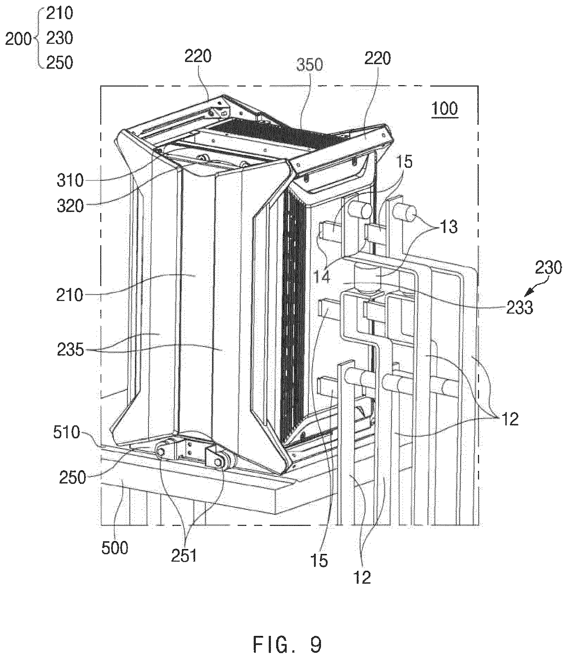

Referring to FIGS. 8 and 9, the inverter stack 100 according to the present disclosure may further include a base plate 500 on which the lower part of the case 200 is seated and that is detachably coupled to the mounting frame 11. The base plate 500 may have a mounting rail 510 formed on a surface thereof that faces the case 200.

The case 200 may further include a lower frame 250 and rail wheels 251. The lower frame 250 may be detachably attached to the bottom of the main body frame 210. The rail wheels 251 may be provided at the lower frame 250 and may perform a rolling motion along the mounting rail 510 to guide connection and disconnection of the modular bus bars 410 and the slide terminal recesses 15.

Specifically, in the case of the inverter stack 100 having the modular structure, stable design is required because an impact is likely to be applied to the switching semiconductor element (IGBT) when the DC slide bus bars 411 and the AC slide bus bars 412, which are mounted on the rear part, are mounted in or separated from the slide terminal recesses 15 at the time of connection of the power supply. However, in the related art, due to the clearance between the guide rail provided on the mounting 10 and the slide terminal recesses 15, a large amount of time is taken for attachment or detachment, and it is difficult to perform maintenance. Furthermore, the inverter stack 100 in the related art has a problem in that it is difficult to make a change to the integrated structure because attachment and detachment of the guide rail and the modular bus bars 410 are impossible.

To solve the problem, the inverter stack 100 according to the present disclosure includes the removable modular bus bars 410 and separately includes the detachable base plate 500 on the mounting frame 11, thereby preventing the clearance between the slide terminal recesses 15 and the mounting rail 510. Specifically, the modular bus bars 410 may be inserted into the slide terminal recesses 15 by mounting the base plate 500 in the position corresponding to the slide terminal recesses 15 and pushing the base plate 500 through the mounting rail 510 and the rail wheels 251. At this time, the modular bus bars 410 and the power supply may be connected together.

The main body frame 210 may further include handles 220 made of an insulating material. The handles 220 may be exposed to the outside after the cover 230 is mounted. A worker may mount the case 200 by pushing the case 200 toward the mounting frame 11 while holding the handles 220. Accordingly, the worker may be prevented from encountering electric shock.

As described above, the inverter stack capable of structure modification according to the present disclosure may implement both the modular structure and the integrated structure using one inverter stack, and thus the installation method of the inverter stack or the structure for connecting the inverter stack in parallel may be diversely modified, which makes it possible to easily access a market requiring the inverter stack. In addition, the inverter stack may reduce development time for configuring an inverter system having various structures and may achieve cost savings.

According to the embodiments of the present disclosure, the inverter stack capable of structure modification may implement both the modular structure and the integrated structure using one inverter stack, and thus the installation method of the inverter stack or the structure for connecting the inverter stack in parallel may be diversely modified, which makes it possible to easily access a market requiring the inverter stack. In addition, the inverter stack may reduce development time for configuring an inverter system having various structures and may achieve cost savings.

## Claims

1. An inverter stack(100) capable of structure modification comprising:
a case(200) having an interior space and including a main body frame (210) and a cover (230), wherein the main body frame (210) includes a front part, a rear part facing the front part, an upper part provided at the tops of the front part and the rear part, and a lower part facing the upper part, and the cover (230) is detachably coupled to the main body frame (210) and covers the main body frame(210);
a circuit unit(310) provided in the interior space;
an inverter controller provided in the interior space and connected to the circuit unit(310) to transfer a signal; and
a bus bar(400) provided in the case(200) and connected to the circuit unit(310), the bus bar(400) being electrically connected to a power supply,
**characterized in that** the bus bar(400) includes:
a modular bus bar(410) formed to protrude from the rear part of the main body frame (210) and configured to pass through the cover(230); and
an integrated bus bar(450) provided on at least one pair of parts facing each other, among the front part, the rear part, the upper part, and the lower part, the integrated bus bar(450) being covered with the cover(230),
wherein the inverter stack(100) is selectively changed to a modular structure in which the modular bus bar(410) is connected with the power supply or an integrated structure in which the integrated bus bar(450) is connected with the power supply, by coupling the cover(230) to the main body frame(210) or separating the cover(230) from the main body frame(210),
the cover(230) includes:
a front cover(231) configured to cover the front part of the main body frame(210);
a rear cover(233) configured to cover the rear part; and
a side cover(235) configured to cover side parts on opposite sides of the front part and the rear part, and
wherein the modular bus bar(410) is connected to the circuit unit(310) so as to be removable.

2. The inverter stack of claim 1, wherein the rear cover has a through-hole formed therein, through which the modular bus bar passes.

3. The inverter stack of claim 1, wherein the inverter controller is implemented with a gate control unit (GCU) (330), and
wherein the gate control unit(330) is attached to the front part of the main body frame (210) when the modular structure is applied, and the gate control unit(330) is attached to side parts on opposite sides of the front part and the rear part when the inverter stack(100) is changed from the modular structure to the integrated structure.

4. The inverter stack(100) of claim 3, wherein the gate control unit(330) includes an indicator(331) configured to indicate whether the inverter stack(100) is in good condition, and wherein the front cover(231) has an indication hole(232) for the indicator(331).

5. The inverter stack(100) of claim 1, wherein the modular bus bar(410) includes a DC slide bus bar(411) connected to a DC power supply and an AC slide bus bar (412) connected to an AC power supply.

6. The inverter stack(100) of claim 1, wherein the inverter stack(100) having the modular structure is mounted on a mounting(10) that includes a mounting frame(11), a mounting bus bar(12) provided on the mounting frame(11), and a slide terminal recess(15) that is provided on the mounting bus bar(12) and into which the modular bus bar(410) is inserted,
wherein the inverter stack(100) further comprises a base plate(500) on which the lower part of the case(200) is seated and that is detachably coupled to the mounting frame(210), the base plate(500) having a mounting rail(510) formed on a surface thereof that faces the case(200), and
wherein the case(200) further includes:
a lower frame(250) detachably attached to a lower portion of the main body frame(210); and
a rail wheel(251) provided at the lower frame(250) to perform a rolling motion along the mounting rail(510) to guide connection and disconnection of the modular bus bar(410) and the slide terminal recess(15).

7. The inverter stack(100) of claim 1, wherein the main body frame(210) further includes a handle(220) made of an insulating material.

8. The inverter stack(100) of claim 1, wherein the integrated bus bar(450) includes a DC connection bus bar(451) connected to a DC power supply and an AC connection bus bar(452) connected to an AC power supply.

9. The inverter stack(100) of claim 1, wherein the circuit unit(310) includes a power conversion semiconductor and a charging capacitor(320).

## Patentansprüche

1. Inverterstapel (100) mit Fähigkeit zur Strukturmodifikation, umfassend:
ein Gehäuse (200), das einen Innenraum hat und einen Hauptkörperrahmen (210) und eine Abdeckung (230) aufweist, wobei der Hauptkörperrahmen (210) ein Vorderteil, ein dem Vorderteil zugewandtes Rückteil, ein Oberteil, das oben auf dem Vorderteil und dem Rückteil vorgesehen ist, und ein dem Oberteil zugewandtes Unterteil aufweist, und die Abdeckung (230) abnehmbar an den Hauptkörperrahmen (210) angeschlossen ist und den Hauptkörperrahmen (210) abdeckt;
eine Schaltungseinheit (310), die im Innenraum vorgesehen ist;
eine Invertersteuerung, die im Innenraum vorgesehen und an die Schaltungseinheit (310) angeschlossen ist, um ein Signal zu übertragen; und
eine Sammelschiene (400), die in dem Gehäuse (200) vorgesehen und an die Schaltungseinheit (310) angeschlossen ist, wobei die Sammelschiene (400) elektrisch an eine Energieversorgung angeschlossen ist,
**dadurch gekennzeichnet, dass** die Sammelschiene (400) aufweist:
eine modulare Sammelschiene (410), die dazu ausgebildet ist, vom Rückteil des Hauptkörperrahmens (210) vorzustehen, und dazu ausgelegt ist, durch die Abdeckung (230) hindurchzutreten; und
eine integrierte Sammelschiene (450), die an mindestens einem Paar von einander zugewandten Teilen, darunter dem Vorderteil, dem Rückteil, dem Oberteil und dem Unterteil vorgesehen ist, wobei die integrierte Busschiene (45) mit der Abdeckung (230) abgedeckt ist,
wobei der Inverterstapel (100) selektiv in eine modulare Struktur, in der die modulare Sammelschiene (410) mit der Energieversorgung verbunden ist, oder eine integrierte Struktur abgeändert wird, in der die integrierte Sammelschiene (450) mit der Energieversorgung verbunden ist, indem die Abdeckung (230) an den Hauptkörperrahmen (210) angeschlossen oder die Abdeckung (230) vom Hauptkörperrahmen (210) getrennt wird,
die Abdeckung (230) weist auf:
eine vordere Abdeckung (231), die dazu ausgelegt ist, das Vorderteil des Hauptkörperrahmens (210) abzudecken;
eine hintere Abdeckung (233), die dazu ausgelegt ist, das Rückteil abzudecken; und
eine Seitenabdeckung (235), die dazu ausgelegt ist, Seitenteile auf entgegengesetzten Seiten des Vorderteils und des Rückteils abzudecken, und
wobei die modulare Sammelschiene (410) entfernbar an die Schaltungseinheit (310) angeschlossen ist.

2. Inverterstapel nach Anspruch 1, wobei die hintere Abdeckung eine darin ausgebildete Durchgangsöffnung hat, durch welche die modulare Sammelschiene hindurchtritt.

3. Inverterstapel nach Anspruch 1, wobei die Invertersteuerung mit einer Gate-Steuereinheit (GCU) (330) ausgeführt ist, und
wobei die Gate-Steuereinheit (330) am Vorderteil des Hauptkörperrahmens (210) angebracht ist, wenn die modulare Struktur angesetzt ist, und die Gate-Steuereinheit (330) an Seitenteilen auf entgegengesetzten Seiten des Vorderteils und des Rückteils angebracht ist, wenn der Inverterstapel (100) von der modularen Struktur in die integrierte Struktur abgeändert wird.

4. Inverterstapel (100) nach Anspruch 3, wobei die Gate-Steuereinheit (330) einen Anzeiger (331) aufweist, der dazu ausgelegt ist, anzugeben, ob sich der Inverterstapel (100) in einem guten Zustand befindet, und
wobei die vordere Abdeckung (231) eine Anzeigeöffnung (232) für den Anzeiger (331) hat.

5. Inverterstapel (100) nach Anspruch 1, wobei die modulare Sammelschiene (410) eine Gleichstrom-Gleitsammelschiene (411), die an eine Gleichstromenergieversorgung angeschlossen ist, und eine Wechselstrom-Gleitsammelschiene (412) aufweist, die an eine Wechselstromenergieversorgung angeschlossen ist.

6. Inverterstapel (100) nach Anspruch 1, wobei der Inverterstapel (100) mit der modularen Struktur an einer Halterung (10) montiert ist, die einen Halterungsrahmen (11), eine Halterungssammelschiene (12), die am Halterungsrahmen (11) vorgesehen ist, und eine Gleitanschlussausnehmung (15) aufweist, die an der Halterungssammelschiene (12) vorgesehen ist, und in welche die modulare Sammelschiene (410) eingesetzt wird,
wobei der Inverterstapel (100) darüber hinaus eine Grundplatte (500) umfasst, auf der das Unterteil des Gehäuses (200) sitzt, und die abnehmbar an den Halterungsrahmen (210) angeschlossen ist, wobei die Grundplatte (500) eine Montageschiene (510) hat, die auf einer Fläche von dieser ausgebildet ist, die dem Gehäuse (200) zugewandt ist, und
wobei das Gehäuse (200) darüber hinaus aufweist:
einen unteren Rahmen (250), der abnehmbar an einem unteren Abschnitt des Hauptkörperrahmens (210) angebracht ist; und
ein Schienenrad (251), das am unteren Rahmen (250) vorgesehen ist, um eine Rollbewegung entlang der Montageschiene (510) zu vollziehen, um eine Verbindung und Abtrennung der modularen Busschiene (410) und der Gleitanschlussausnehmung (15) anzuführen.

7. Inverterstapel (100) nach Anspruch 1, wobei der Hauptkörperrahmen (210) darüber hinaus einen Handgriff (220) aufweist, der aus einem Isoliermaterial hergestellt ist.

8. Inverterstapel (100) nach Anspruch 1, wobei die integrierte Sammelschiene (450) eine Gleichstromanschluss-Sammelschiene (451), die an eine Gleichstromenergieversorgung angeschlossen ist, und eine Wechselstromanschluss-Sammelschiene (452) aufweist, die an eine Wechselstromenergieversorgung angeschlossen ist.

9. Inverterstapel (100) nach Anspruch 1, wobei die Schaltungseinheit (310) einen Energieumwandlungshalbleiter und einen Ladekondensator (320) aufweist.

## Revendications

1. Empilement d'inverseurs (100) capable de modification de structure, comprenant :
un boîtier (200) présentant un espace intérieur et incluant un cadre de cors principal (210) et un couvercle (230), sachant que le cadre de corps principal (210) inclut une partie avant, une partie arrière faisant face à la partie avant, une partie supérieure prévue au niveau des dessus de la partie avant et de la partie arrière, et une partie inférieure faisant face à la partie supérieure, et le couvercle (230) est couplé de manière détachable au cadre de corps principal (210) et recouvre le cadre de corps principal (210) ;
une unité de circuit (310) prévue dans l'espace intérieur ;
un dispositif de commande d'inverseurs prévu dans l'espace intérieur et connecté à l'unité de circuit (310) pour transférer un signal ; et
une barre bus (400) prévue dans le boîtier (200) et connectée à l'unité de circuit (310), la barre bus (400) étant connectée électriquement à une alimentation en énergie électrique,
**caractérisé en ce que** la barre bus (400) inclut :
une barre bus modulaire (410) formée pour dépasser de la partie arrière du cadre de corps principal (210) et configurée pour passer à travers le couvercle (230) ; et
une barre bus intégrée (450) prévue sur au moins une paire de parties se faisant face l'une à l'autre, parmi la partie avant, la partie arrière, la partie supérieure, et la partie inférieure, la barre bus intégrée (450) étant recouverte par le couvercle (230),
sachant que l'empilement d'inverseurs (100) est changé sélectivement en une structure modulaire dans laquelle la barre bus modulaire (410) est connectée à l'alimentation en énergie électrique ou une structure intégrée dans laquelle la barre bus intégrée (450) est connectée à l'alimentation en énergie électrique, en couplant le couvercle (230) au cadre de corps principal (210) ou en séparant le couvercle (230) du cadre de corps principal (210),
le couvercle (230) inclut :
un couvercle avant (231) configuré pour recouvrir la partie avant du cadre de corps principal (210) ;
un couvercle arrière (233) configuré pour recouvrir la partie arrière ; et
un couvercle latéral (235) configuré pour recouvrir des parties latérales de couvercle de côtés opposés de la partie avant et de la partie arrière, et
sachant que la barre bus modulaire (410) est connectée à l'unité de circuit (310) de manière à être amovible.

2. L'empilement d'inverseurs de la revendication 1, sachant que le couvercle arrière présente un trou traversant formé dans celui-ci, à travers lequel la barre bus modulaire passe.

3. L'empilement d'inverseurs de la revendication 1, sachant que le dispositif de commande d'inverseurs est implémenté avec une unité de commande de grille (GCU) (330), et
sachant que l'unité de commande de grille (330) est attachée à la partie avant du cadre de corps principal (210) lorsque la structure modulaire est appliquée, et l'unité de commande de grille (330) est attachée à des parties latérales de côtés opposés de la partie avant et de la partie arrière lorsque l'empilement d'inverseurs (100) est changé de la structure modulaire à la structure intégrée.

4. L'empilement d'inverseurs (100) de la revendication 3, sachant que l'unité de commande de grille (330) inclut un indicateur (331) configuré pour indiquer si l'empilement d'inverseurs (100) est en bon état, et
sachant que le couvercle avant (231) présente un trou d'indication (232) pour l'indicateur (331).

5. L'empilement d'inverseurs (100) de la revendication 1, sachant que la barre bus modulaire (410) inclut une barre bus coulissante CC (411) connectée à une alimentation en énergie électrique CC et une barre bus coulissante CA (412) connectée à une alimentation en énergie électrique CA.

6. L'empilement d'inverseurs (100) de la revendication 1, sachant que l'empilement d'inverseurs (100) présentant la structure modulaire est montée sur un montage (10) qui inclut un cadre de montage (11), une barre bus de montage (12) prévue sur le cadre de montage (11), et un évidement de borne coulissant (15) qui est prévu sur la barre bus de montage (12) et dans lequel la barre bus modulaire (410) est insérée,
sachant que l'empilement d'inverseurs (100) comprend en outre une plaque de base (500) sur laquelle la partie inférieure du boîtier (200) prend appui et qui est couplée de manière détachable au cadre de montage (210), la plaque de base (500) présentant un rail de montage (510) formé sur une surface de celle-ci qui fait face au boîtier (200), et
sachant que le boîtier (200) inclut en outre :
un cadre inférieur (250) attaché de manière détachable à une partie inférieure du cadre de corps principal (210) ; et
une roue de rail (251) prévue au niveau du cadre inférieur (250) pour effectuer un mouvement de roulage le long du rail de montage (510) pour guider une connexion et une déconnexion de la barre bus modulaire (410) et de l'évidement de borne coulissant (15).

7. L'empilement d'inverseurs (100) de la revendication 1, sachant que le cadre de corps principal (210) inclut en outre une poignée (220) composée d'un matériau isolant.

8. L'empilement d'inverseurs (100) de la revendication 1, sachant que la barre bus intégrée (450) inclut une barre bus de connexion CC (451) connectée à une alimentation en énergie électrique CC et une barre bus de connexion CA (452) connectée à une alimentation en énergie électrique CA.

9. L'empilement d'inverseurs (100) de la revendication 1, sachant que l'unité de circuit (310) inclut un semiconducteur de conversion d'énergie électrique et un condensateur de charge (320).
